# EUROPÄISCHE PATENTANMELDUNG

(11) **EP 2 522 794 A1**
(43) Veröffentlichungstag der Anmeldung: **14.11.2012**
(21) Anmeldenummer: 11003963.3
(22) Anmeldetag: 13.05.2011
(51) Int. Cl.: E04F 15/16, H01R 12/59, H05K 3/32

(54) **System zur Energie- und/oder Datenbereitstellung sowie Kontaktiereinheit dafür**

(71) Anmelder: Carpet Concept Objekt-Teppichboden GmbH, 33719 Bielefeld (DE)
(72) Erfinder: Trenkamp, Thomas, 46535 Dinslaken (DE); Kemmann, Harald, 42555 Velbert (DE)
(74) Vertreter: Tönhardt, Marion

(57) **Zusammenfassung**

Die Erfindung beschreibt System zur Energie- und/oder Datenbereitstellung, umfassend einen Belag (10) aus textilem Baustoff mit einer Nutzfläche (12), wobei auf der Nutzfläche ein Kontaktraster aufgebaut ist, das aus im Wesentlichen nutzflächenbündig oder versenkt in den Belag eingelassenen Kontaktiereinheiten (20) aufgebaut ist, und ist gekennzeichnet durch eine Unterlageschicht (14), die Leiterbahnen (30, 34, 38) abwechselnder Polarität aufweist, welche durch nichtleitende Bereiche (32, 36) voneinander isoliert sind, wobei zumindest ein Teil der Kontaktiereinheiten (20) im elektrischen Kontakt mit einer Leiterbahn einer ersten Polarität und mit einer Leiterbahn einer zweiten Polarität ist.

## Beschreibung

Die Erfindung betrifft ein System zur Energie- und/oder Datenbereitstellung, umfassend einen Belag aus textilem Baustoff mit einer Nutzfläche, wobei auf der Nutzfläche ein Kontaktraster aufgebaut ist, das aus im Wesentlichen nutzflächenbündig oder versenkt in den Belag eingelassenen Kontaktiereinheiten aufgebaut ist. Die Erfindung betrifft außerdem eine Kontaktiereinheit, die für ein derartiges System geeignet ist.

Verbraucher werden üblicherweise mit Strom versorgt, indem ein Anschlusskabel an eine an der Raumwand angebrachte Netzsteckdose angeschlossen wird. Allerdings können bei der baulichen Konzeption Steckdosen nicht an sämtlichen Orten vorgesehen werden, an denen irgendwann einmal Strom nötig sein wird. In der Raummitte, fern von Raumwänden, ist die Versorgung der Verbraucher besonders schwierig. Der Einbau von Steckdosen in den Boden ist teuer und ästhetisch oft nicht befriedigend, zumal wenn die Steckdosen in Benutzung sind. Zur Versorgung von Verbrauchern werden aus diesen Gründen oft recht lange Anschlusskabel eingesetzt. Werden diese lose über den Boden verlegt, wird die Raumästhetik beeinträchtigt, die Kabel stellen zudem ein Unfallrisiko dar. Sie können zwar grundsätzlich unter einem Bodenbelag verlegt werden, was aber eine flexible Positionierung eines Verbrauchers praktisch unmöglich macht.

Diese Situation, die bei privaten Wohnräumen noch akzeptierbar sein mag, verschärft sich im Office-Bereich, wo regelmäßig eine Vielzahl von Verbrauchern über Energie- und Datenleitungen versorgt werden muss. Auch ist hier die Möblierung nicht statisch und von der gewünschten Raumnutzung abhängig, die bei den heute nötigen flexiblen Teamstrukturen häufig wechseln kann. Die bisher gewählte Lösung besteht darin, den Bodenbereich eines Büros mit Kabelkanälen auszustatten, in denen die erforderlichen Leitungen verlegt und entsprechende Steckdosen montiert werden. Diese Kabelkanäle und Kabelkästen tragen mit einer Bautiefe in der Größenordnung von 15 cm gerade bei mehrstöckigen Bauten nicht unerheblich zur Gebäudehöhe bei. Abgesehen davon fehlt weiterhin die gewünschte Flexibilität für das Aufstellen von Verbrauchern.

Die EP 2 113 180 A2 hat es sich zum Ziel gesetzt, Verbraucher möglichst flexibel mit elektrischer Energie versorgen zu können. Dazu wird ein textiler, gewobener Teppich vorgeschlagen mit längs verlaufenden Kettfäden und quer verlaufenden Schussfäden, wobei drei oder mehr beabstandete, zueinander im Wesentlichen parallele Stromleiter entweder als Kettfäden oder als Schussfäden eingewoben sind. Die Stromleiter ersetzen während des Webvorgangs einen Teil einer Füllkette, einer Bindekette oder der Schussfäden.

Neben derartigen, rein für die Energieversorgung verwendeten Teppichen sind weiter textile Gewebestrukturen bekannt, die in gewisser Weise eine "Intelligenz" aufweisen. So zeigt die DE 103 07 505 A1 eine Textilgewebestruktur mit einer Mehrzahl von Mikroelektronikkomponenten, welche in der Textilgewebestruktur angeordnet sind. Elektrisch leitefähige Fäden koppeln diese Mikroelektronikkomponenten, leitfähige Datenübertragungsfäden sind ebenfalls vorgesehen. Diese Fäden sind am Rande der Textilgewebestruktur jeweils mit elektrischen Schnittstellen bzw. Datenübertragungsschnittstellen versehen.

Weiter bekannt sind Systeme, mit deren Hilfe navigiert und geortet werden kann. Beispielsweise offenbart die WO 2005/071597 A1 einen intelligenten Boden, in dem eine Vielzahl von Transpondern in einem Raster angeordnet ist. Jeder Transponder hat einen Speicher, der Information über Positionsinformation und Zuordnungen für Gegenstände oder Strukturen enthält, die in der Nähe der Transponder angeordnet sind. Die Transponder übertragen Funksignale als Antwort auf empfangene elektromagnetische Anregungsfelder, die beispielsweise mittels geeigneter Hilfsmittel von blinden Personen erzeugt werden. Dabei sind die Transponder bündig in eine Nutzfläche eingebettet, beispielsweise einen Teppich, in Fliesen oder in einen Holzboden.

Ausgehend von diesem Stand der Technik ist es die Aufgabe der vorliegenden Erfindung, ein System zur Energie- und/oder Datenbereitstellung zur Verfügung zu stellen, mit dem eine Energie- und Datenvernetzung im nicht sichtbaren Bereich stattfinden kann.

Diese Aufgabe wird durch ein System zur Energie- und/oder Datenbereitstellung nach Anspruch 1 gelöst. Vorteilhafte Ausgestaltungen sind Gegenstand der Unteransprüche. Eine Kontaktiereinheit für das erfindungsgemäße System ist in Anspruch 10 definiert.

Ein System zur Energie- und/oder Datenbereitstellung, wie es in Anspruch 1 definiert ist, umfasst unter der Nutzfläche des textilen Baustoffes einer Unterlageschicht, die Leiterbahnen abwechselnder Polarität aufweist, welche durch nichtleitende Bereiche voneinander isoliert sind, wobei zumindest ein Teil der Kontaktiereinheiten im elektrischen Kontakt mit einer Leiterbahn der ersten Polarität und mit einer Leiterbahn der zweiten Polarität ist. Damit besteht die Möglichkeit, Energie zur Versorgung von Verbrauchern praktisch über der gesamten Fläche des Belages mittels der Kontaktiereinheiten abzunehmen. Damit ist die erfindungsgemäße Lösung eine Antwort auf die eingangs geschilderte Problematik des "flexible office". Auch die Datenverkabelung (KAT5 und KAT7 und ähnliche Kabel) kann weitgehend entfallen. Die Datenübertragung erfolgt durch Aufinodulation auf die durch die Erfindung bereitgestellten Energieleiter, beispielsweise über ein Power Net-Modul. Insbesondere hat das System der vorliegenden Erfindung die Zielsetzung eines kabellosen Büros und setzt einen völlig neuen Standard in der Architektur, indem bestehende Objekte mit neuen Technologien ergänzt werden.

Obwohl im Folgenden die Erfindung hauptsächlich im Zusammenhang mit Bodenbelägen beschrieben wird, kann sie auch für Wandverkleidungen und Deckenverkleidungen Anwendung finden, und zwar sowohl im Innen- als auch im Außenbereich. Die Nutzfläche kann Schlinge, Velours oder eine Kombination aus beiden umfassen.

Nach einer bevorzugten Ausführungsform sind die Leiterbahnen flächige Leiterbahnen. Dadurch wird es möglich, Ströme ohne wesentliche Erwärmung des textilen Baustoffes zu übertragen.

Weiter vorteilhaft sind die Leiterbahnen parallel zu einander geführt, was die Kontaktierung der Kontaktiereinheiten erleichtert. Die Baumöglichkeiten werden noch verbessert und können einfacher standardisiert werden, wenn die Leiterbahnen untereinander die gleiche Breite aufweisen und die nichtleitenden Bereiche untereinander die gleiche Breite aufweisen.

Vorzugsweise ist das Kontaktraster aus identischen Polygonen aufgebaut, wobei die Ecken der Polygone mit jeweils einer Kontaktiereinheit belegt sind.

Es hat sich als besonders vorteilhaft herausgestellt, Polygone zu verwenden, die gleichseitige Trapeze sind, deren einer Durchmesser der Summe aus der gesamten Breite zweier benachbarter Leiterbahnen und dem Zweifachen der Breite eines nichtleitenden Bereiches entspricht. Der zweite Durchmesser kann variiert werden, wird aber vorzugsweise für einen Belag als Konstante gewählt.

Die Anbindung an die Netzversorgung gelingt vorzugsweise mit einer elektronischen Sockelleise, welche eine Schutzkleinspannung bis zu 40 V DC in die Leiterbahnen der Unterlageschicht bringt.

Dazu weist die Sockelleiste vorzugsweise einen entsprechenden Wandler, beispielsweise von 230 V AC nach 40 V DC auf.

Die Sockelleiste ist weiter gekennzeichnet durch mindestens jeweils einen Reihenverbinder für Phase, Nullleiter und Schutzleiter.

Eine Kontaktiereinheit zum Kontaktieren von Leiterbahnen unterschiedlicher Polarität und zum Weiterleiten von Energie und/oder Daten, das für das beschriebene System zur Energie-und/oder Datenbereitstellung geeignet ist, ist in Anspruch 10 definiert. Es umfasst einen Rahmen aus elektrisch isolierendem Material, in dem eine erste Kontaktplatte und eine zweite Kontaktplatte elektrisch isoliert voneinander gehalten sind. Mindestens ein Kontaktbein zum Kontaktieren einer Leiterbahn einer ersten Polarität, das sich von der ersten Kontaktplatte erstreckt und mindestens ein Kontaktbein zum Kontaktieren einer Leiterbahn einer zweiten Polarität, die von der ersten Polarität unterschiedlich ist, das sich von der zweiten Kontaktplatte erstreckt, sind vorgesehen, wobei die erste Kontaktplatte und die zweite Kontaktplatte in einer gemeinsamen Ebene liegend angeordnet sind und sich die Kontaktbeine im Wesentlichen senkrecht zu der Ebene erstrecken.

Vorzugsweise sind jeder Kontaktplatte zwei voneinander beabstandete Kontaktbeine zugeordnet, welche Eingriffsmittel zum Halten einer die Kontaktbeine verbindenden Klemmbrücke aufweisen.

Mit dem beschriebenen System zur Energie- und/Datenbereitstellung sowie mit einer Vielzahl derartiger Kontaktiereinheiten lässt sich eine Stromversorgung für Geräte, insbesondere im Office-Bereich aufbauen. Dazu werden Stromzuführungen für die Versorgung der Geräte zur Verfügung gestellt, welche durch oder entlang von Möbelabschnitten geführt sind, die zur Auflage auf eine Bodenfläche bestimmt sind, wobei die Stromzuführungen auf ein Paar federvorbelasteter Kontakte geführt sind, welche entsprechenden den Abmessungen der Kontaktplatten einer Kontaktiereinheit dimensioniert sind.

Im Folgenden soll die Erfindung anhand der beigefügten Zeichnung näher erläutert werden. Dabei sind die Darstellungen sehr schematisch und nicht notwendigerweise maßstabsgetreu. Es zeigt:
- Figur 1: eine Draufsicht auf ein System zur Energie- und/oder Datenbereitstel-lung gemäß einer ersten Ausführungsform der vorliegenden Erfin-dung;
- Figur 2: eine Schnittansicht entlang der Linie A-A aus Figur 1;
- Figur 3: eine Draufsicht ähnlich der Figur 1, bei der jedoch der textile Baustoff weggelassen ist;
- Figur 4: eine Ausführungsform einer Kontaktiereinheit gemäß der vorliegen-den Erfindung in perspektivischer Ansicht;
- Figuren 4a und 4b: alternative Gestaltungen für die Kontaktiereinheit in Draufsicht;
- Figur 5: eine Schnittansicht durch die Kontaktiereinheit der Figur 4;
- Figur 6: eine Detailansicht der Kontaktierung einer Kontakteinheit;
- Figur 7: ein Beispiel einer Ausführungsform für federbelastete Kontakte im Zusammenwirken mit einer Kontaktiereinheit;
- Figur 8: eine Schnittansicht im Bereich einer Kontaktiereinheit;
- Figur 9: eine schematische Darstellung, teilweise weggeschnitten, eines Mö-belfußes;
- Figur 10: eine schematische Darstellung eines Adapterstückes;
- Figur 11 1: eine Ansicht auf ein Adapterstück mit Befestigungsmagneten;
- Figur 12: eine schematische Darstellung, die das Zusammenwirken eines Kon-taktrasters mit den Leiterbahnen veranschaulicht;
- Figur 13 3: ein beispielhaftes Layout für die Gestaltung eines Büros mit mehreren Arbeitsplätzen;
- Figur 14: eine perspektivische Ansicht einer Sockelleiste zur Verwendung bei der vorliegenden Erfindung; und
- Figur 15: eine Stirnansicht der Sockelleiste aus Figur 14.

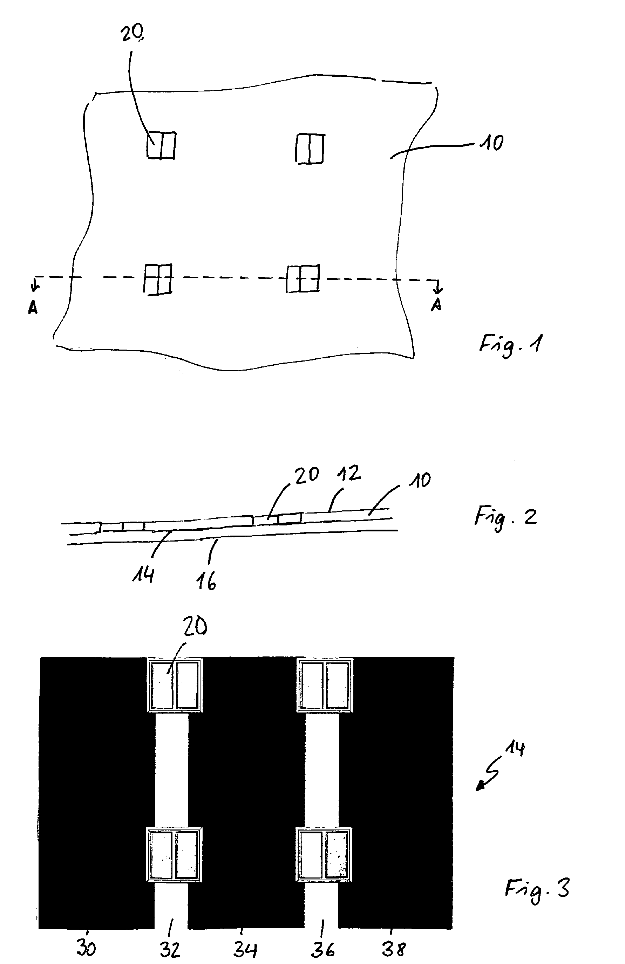

Figur 1 zeigt eine Draufsicht auf eine Ausfiihrungsform eines Systems zur Energie- und/oder Datenbereitstellung gemäß der vorliegenden Erfindung. Das System umfasst einen Belag 10 aus textilem Baustoff, in den eine Vielzahl von Kontaktiereinheiten 20 in einem Kontaktraster angeordnet ist. Zumindest ein Teil der Kontaktiereinheiten 20 ist, wie später noch beschrieben wird, im elektrischen Kontakt mit Leiterbahnen, die in dem erfindungsgemäßen System vorgesehen sind. Jedoch können einige der Kontaktiereinheiten 20 auch lediglich zu dekorativen Zwecken vorgesehen sein. In diesem Fall wird dafür zu sorgen sein, dass die Kontaktiereinheiten in den Belag 10 eingebunden werden, ohne dass sie mit anderen Komponenten des erfindungsgemäßen Systems in elektrischen Kontakt kommen. Eine Möglichkeit dazu ist in der DE 100 51 545 B4 beschrieben. Dort können in flächenhaften Spiegelgründen metallische Oberflächeneinlagen ortsfest angeordnet werden, wobei eine Klebschicht zur besseren Haftvermittlung vorgesehen ist. Es versteht sich, dass die Kontaktiereinheiten 20 in Formgebung und farblicher Gestaltung unterschiedlich sein können, um verschiedensten ästhetischen Bedürfnissen Rechnung zu tragen.

Figur 2 zeigt eine Schnittansicht entlang der Linie A-A aus Figur 1. Die Kontaktiereinheiten 20 sind im Wesentlichen bündig mit der Nutzfläche 12 des Belages 10 in diesen eingelassen. Bei der vorliegenden Darstellung entspricht die Dicke einer Kontakteinheit 20 der Dicke des Belages 10. Andere Gestaltungen sind denkbar, so lange die Dicke des Kontaktierelementes 20 die Dicke des Belages 10 nicht oder allenfalls unwesentlich übersteigt. Dies ist insbesondere für Anwendungen wichtig, bei denen der Belag 10 als Bodenbelag zum Einsatz kommt.

Die Kontakteinheiten 20 sind im elektrischen Kontakt mit einer Unterlageschicht 14, die wiederum auf einer Abschlussschicht 16 aufliegt.

Einzelheiten der Kontaktierungen ergeben sich aus der Figur 3, die eine Draufsicht auf das erfindungsgemäße System ähnlich der Figur 1 zeigt, wobei jedoch der Belag 10 weggelassen ist, um die Anordnung der Kontaktiereinheiten 20 in Bezug auf die Unterlageschicht 14 zu verdeutlichen. Die Unterlageschicht 14 weist eine Vielzahl von Leiterbahnen 30, 34, 38 auf, die durch nichtleitende Bereiche 32, 36 voneinander getrennt sind. Dabei sind die Leiterbahnen 30, 34, 38 mit abwechselnder Polarität angeordnet, so dass zum Beispiel die Leiterbahn 30 eine positive Polarität hat, die Leiterbahn 34 eine negativ Polarität, die Leiterbahn 38 wieder eine positive Polarität usw., wobei sich dieses Schema je nach der gewünschten Größe des Belages fortsetzt. Damit bezüglich ihrer Größe standardisierte Kontakteinheiten 20 verwendet werden können, weisen die nichtleitenden Bereiche 32, 36 untereinander die gleiche Breite auf, so dass Kontaktiereinheiten 20 mit entsprechend gewählten Abmessungen diese überbrücken und in Kontakt mit einer Leiterbahn einer ersten Polarität und einer Leiterbahn einer zweiten Polarität kommen können. Aus herstellungstechnischen Gründen zweckmäßig ist es, wenn außerdem auch die Leiterbahnen 30, 34, 38 untereinander die gleiche Breite aufweisen. Die Leiterbahnen 30, 34, 38 sind flächig ausgeführt und verlaufen geradlinig und parallel zueinander, ebenso wie die nichtleitenden Bereiche 32, 36.

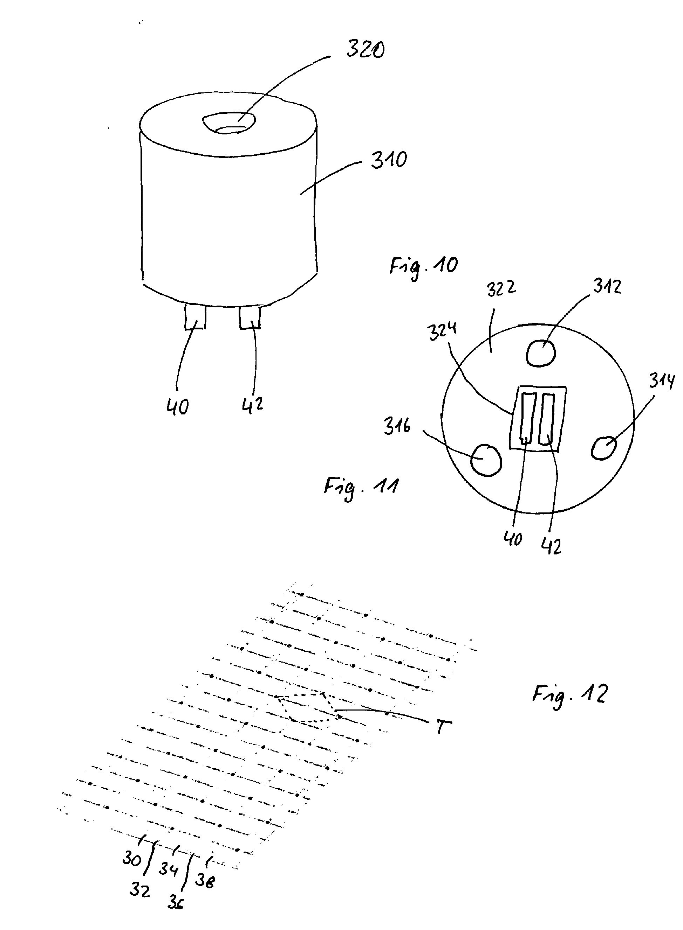

Gemäß den Figuren 1 und 3 ist in der Nutzfläche des Belages 10 ein Kontaktraster aus Kontaktiereinheiten 20 aufgebaut, die an den Ecken identischer Polygone, im vorliegenden Fall Quadrate, angeordnet sind. Kontaktraster aus anderen Polygonen sind denkbar, beispielsweise mit gleichseitigen Trapezen, wie es später noch mit Bezug auf Figur 12 erläutert wird. Bevorzugt sind Polygone, mit denen sich die Nutzfläche des Belages 10 flächig belegen lässt, also Dreiecke, Vierecke, Sechsecke.

Eine für die Erfindung geeignete Unterlageschicht kann beispielsweise mittels einer Technik hergestellt werden, die in der WO 2008/155350 A1 beschrieben ist, oder mittels eines Verfahrens gemäß der EP 1 299 916 B1.

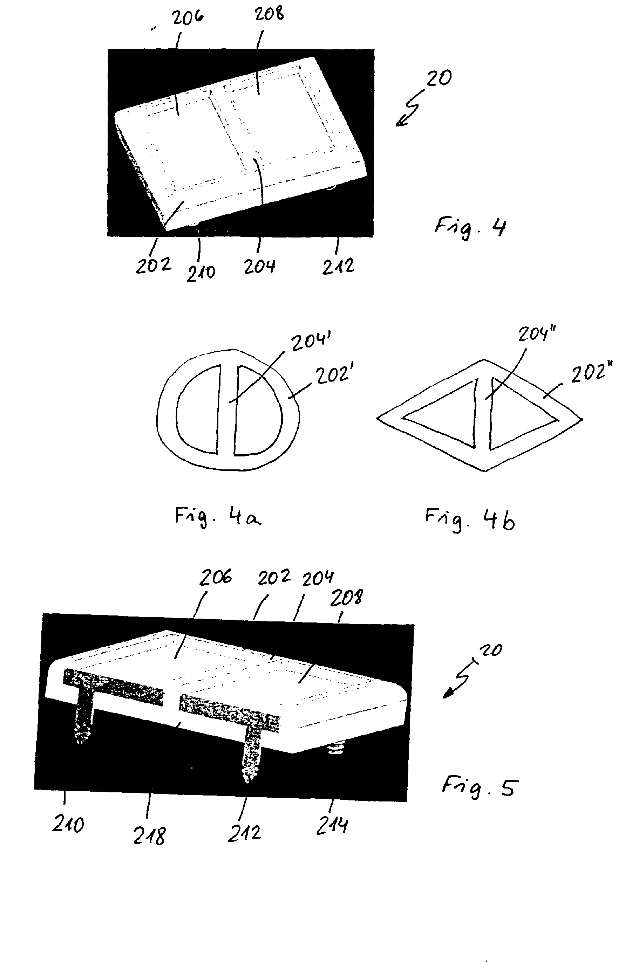

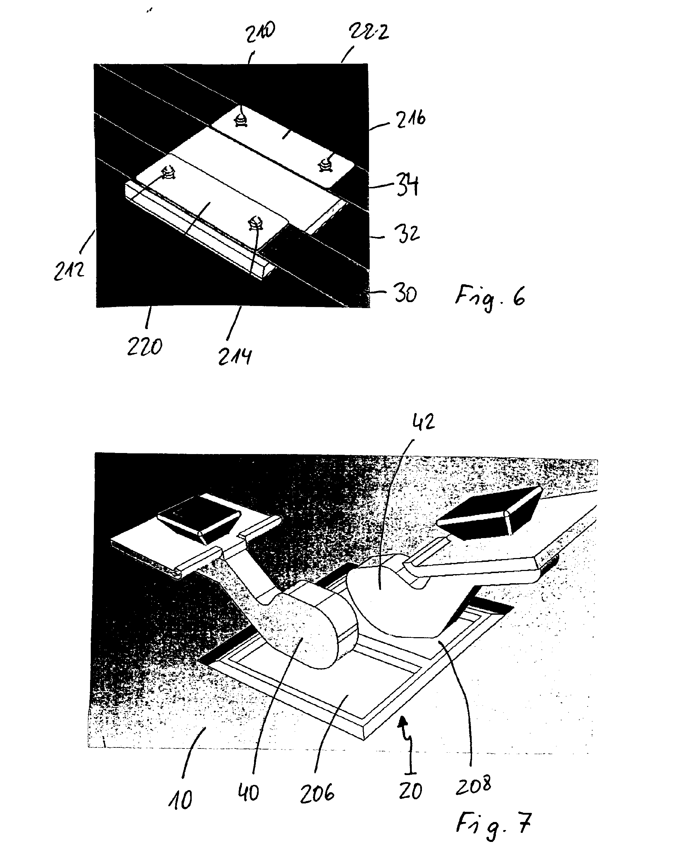

Figur 4 zeigt in einer perspektivischen Ansicht eine Kontaktiereinheit 20, die in einem erfindungsgemäßen System zur Energie- und/oder Datenbereitstellung gemäß der vorliegenden Erfindung zur Anwendung kommen kann. Die Kontaktiereinheit 20 umfasst einen umlaufenden Rahmen 202 aus elektrisch isolierendem Material, beispielsweise einem Kunststoff, in dem eine erste Kontaktplatte 206 und eine zweite Kontaktplatte 208 elektrisch isoliert voneinander gehalten sind. Im vorliegenden Beispiel gelingt dies mittels eines Steges 204, der die Kontaktplatten 206, 208 voneinander getrennt hält und der auch als Positionierhilfe beim Kontaktieren mit federbelasteten Kontakten dient, die später noch im Zusammenhang mit der Figur 7 beschrieben werden. Für jede der Kontaktplatten 206, 208 ist mindestens ein Kontaktbein 210, 212 vorgesehen, über das die Kontaktierung mit den Leiterbahnen der Unterlageschicht (Figur 3) vorgenommen wird. Beide Kontaktplatten 206, 208 sind in einer gemeinsamen Ebene liegend angeordnet, wobei sich die Kontaktbeine 210, 212 im Wesentlichen senkrecht zu dieser Ebene erstrecken.

In der Figur 4 ist der Rahmen 202 als ein rechteckiger Rahmen dargestellt. Andere Ausführungsformen sind möglich. So zeigt die Figur 1 eine Draufsicht auf einen kreisförmigen Rahmen 202', der durch einen Steg 204' geteilt wird. Figur 4b zeigt einen Ausführungsform mit einem rautenförmigen Rahmen 202", der durch einen Steg 204" halbiert wird. Bei allen Ausführungsformen kann grundsätzlich auf den Steg 204, 204', 204" verzichtet werden, so lange sichergestellt ist, dass die Kontaktplatten 206, 208 auch bei bestimmungsgemäßem Einsatz in ihrer korrekten Position verbleiben. Die Rahmen 202, 202', 202" können in den unterschiedlichsten Farben ausgelegt werden. Auch können Rahmenformen kombiniert werden, so dass beispielsweise die in der Figur 4a linke Hälfte des Rahmens 202' und die in der Figur 4b rechte Hälfte des Rahmens 202' kombiniert werden. Die Kontaktplatten 206, 208 sind beispielsweise Metallplatten, können aber auch aus einem elektrisch leitenden Polymer oder dergleichen bestehen.

Figur 5 zeigt eine Schnittansicht durch die Kontaktiereinheit 20 der Figur 4. Jede Kontaktplatte 206, 208 ist in den Rahmen 202 eingelassen und durch Hinterschneidungen im Rahmen 202 sowie im Steg 204 gesichert. Von jeder Kontaktplatte, bei der Kontaktplatte 208 deutlich zu erkennen, erstrecken sich zwei voneinander beabstandete Kontaktbeine 212, 214 durch die Bodenplatte 218 des Rahmens 202.

Die Kontaktiereinheiten 20 können, je nach Anwendung, wasserdicht umspritzt sein. Als Option kann eine Schutzkappe für nicht genutzte Kontaktiereinheiten vorgesehen sein. Diese dient auch dazu, Beschädigungen durch Abrieb vorzubeugen, der beim Staubsaugen, durch Schuhe oder Rollen von Bürostühlen entstehen kann. Die Kontakteinheiten 20 werden im vordefinierten Kontaktraster auf den Belag aus textilem Baustoff bestückt, im Regelfall flächenbündig zur Nutzschicht, falls erforderlich, können sie aber auch zum Trittschutz in den Belag eingesenkt werden.

Figur 6 zeigt die Kontaktierung der Kontaktiereinheiten 20. Die vorbereiteten Stellen sind so gewählt, dass die die nichtleitenden Bereiche 32, 36 zwischen den Leiterbahnen 30, 34, 38 (vgl. Figur 3) überbrücken, wobei die Kontaktbeine 210, 216, die der ersten Kontaktplatte (in der Zeichnungsfigur nicht sichtbar) zugeordnet sind, die Leiterbahn 34 einer ersten Polarität (beispielsweise Minus) kontaktieren, während die Kontaktbeine 212, 214 der zweiten Kontaktplatte die Leiterbahn 30 einer zweiten Polarität (beispielsweise Plus) kontaktieren. Der Kontakt wird durch jeweils eine Klemmbrücke 220, 222 gehalten, in die die jeweiligen Kontaktbeine 212, 214 bzw. 210, 216 tauchen und durch geeignete Einrichtungen gehalten werden.

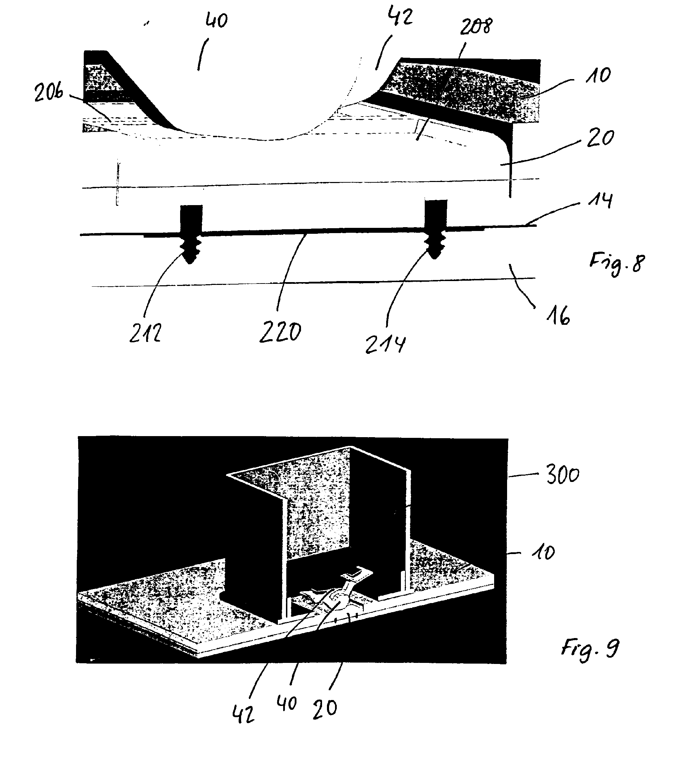

Die Weiterleitung der elektrischen Energie erfolgt, wie in der Figur 7 dargestellt, über federbelastete Kontakte 40, 42, welche Bestandteil eines Adapters sind, der im Zusammenhang mit den Figuren 10 und 11 noch näher beschrieben wird. Jeder federbelastete Kontakt 40, 42 ist einer jeweiligen Kontaktplatte 206, 208 der Kontaktiereinheit 20 zugeordnet. Die Kontakte 40, 42 erzeugen dabei einen Aufpressdruck größer als 16 N. Die Situation der Figur 7 ist in einer Schnittansicht weiter in Figur 8 dargestellt.

Figur 8 ist eine schematische Teildarstellung in Schnittansicht, auf der das Zusammenwirken der federbelasteten Kontakte 40, 42 mit den Kontaktplatten 206, 208 einer Kontakteinheit 20. Die Kontaktiereinheit 20 ist in den Belag 10 eingesenkt. Der Kontakt 40 liegt auf der Kontaktplatte 208 auf, der Kontakt 42 auf der Kontaktplatte 206. Da die Kontaktplatten 206, 208, wie oben erläutert, voneinander isoliert sind, gilt dieses damit auch für die Kontakte 40, 42. Die Kontaktbeine 212, 214 der Kontaktplatte 208 erstrecken sich durch die die Leiterbahnen enthaltende Unterlage 14 und werden von einer Klemmbrücke 220, die eine Gegenlage bildet, gehalten. Die Eingriffsbereiche der Kontaktbeine 212, 214 sind in der Abschlussschicht 16 versenkt. Entsprechendes gilt für die Kontaktbeine der Kontaktplatte 206.

Figur 9 zeigt die Situation schematisch im Zusammenhang mit der Stromführung durch ein Möbelbein, beispielsweise des Beines eines Schreibtisches. Das ein Hohlprofil aufweisende Möbelbein 300 wird so platziert, dass seine Öffnung über einer in den Belag 10 versenkten Kontaktiereinheit 20 liegt. Die Kontakte 40, 42, die normalerweise Bestandteil eines hier nicht gezeigten Adapters sind, sitzen auf den entsprechenden Kontaktplatten der Kontaktiereinheit 20.

Ein Beispiel für einen Adapter zeigt Figur 10. Er besteht aus einem beispielsweise zylindrischen Adapterkörper 310, dessen Gewicht so festgelegt ist, dass er unter Wirkung der Schwerkraft die für die elektrische Kontaktierung notwendigen 16 N auf die Kontakte 40, 42, die an seiner Unterseite frei liegen, aufbringt. Im Inneren des Adapterkörpers 30 sind die Kontakte 40, 42 federbelastet gelagert. Weiterhin gehen von ihnen Leitungen ab, die zu einer Steckeröffnung 320 oder auch zu mehreren Steckeröffnungen führen, an die Geräte wie üblich anzuschließen sind. Der Adapter kann, wenn gewünscht, einen Rückwandler enthalten.

Anstelle eines Möbelbeins kann die Kontaktierung auch direkt zu einem Verbraucher hergestellt werden. Es ist auch denkbar, einen Zentralständer zu kontaktieren, der eine Vielzahl von Steckeröffnungen für übliche Stecker aufweist.

Bisher ist die Erfindung weitgehend so beschrieben worden, dass der Belag 10 als Bodenbelag gestaltet ist. Es ist aber auch denkbar, Wände oder sogar Decken mit einem erfindungsgemäßen Belag zu versehen. Dann ist es zweckmäßig, die Kontaktierung auf andere Weise als durch die Schwerkraft vermittelt vorzunehmen.

Ein Beispiel dazu ist in Figur 11 gezeigt, die eine Ansicht auf die Unterseite des Adapters der Figur 10 zeigt. Die Kontakte 40, 42 ragen durch eine Öffnung 324 im Boden 322 des Adapters und sind von Magneten 312, 314, 316 umgeben, die in den Boden 322 des Adapterkörpers eingelassen sind. Diese werden dann von entsprechenden magnetischen Gegenstücken an der Wand oder an der Decke gehalten und erzeugen den notwendigen Anpressdruck für die Kontakte.

Besondere Bedeutung für die Erfindung hat die Ausgestaltung des Kontaktrasters für die jeweilige Anwendung. Wenn beispielsweise die Erfindung als Bodenbelag in einem Büro verwendet wird, muss auf verschiedene Möblierungssituationen Rücksicht genommen werden. Bürotischabmessungen von 1.80 m x 0.90 m, 1.90 m x 0.90 m und 2.00 m x 0.90 m sind üblich. Diese werden in der Regel am häufigsten für die Kontaktierung benutzt, wenn auch denkbar ist, einen Leuchtenfuß oder eine Zentraleinheit, von der üblicherweise verwendete Stecker abgehen, zu kontaktieren. Weiterhin sollte das Kontaktraster möglichst einheitlich Räume versorgen, die unterschiedliche Belegung mit Arbeitsplätzen haben.

Es hat sich als besonders vorteilhaft herausgestellt, als Kontaktraster ein "gestauchtes Rautenmuster" zu verwenden, wie es schematisch in der Figur 12 dargestellt ist. Dieses "gestauchte Rautenmuster" besteht aus gleichzeitigen Trapezen T, deren Hauptachse zwei Leiterbahnen (z. B. 30, 40) überbrückt, während die Nebenachsen sich in Richtung der nicht leitenden Bereiche (z. B. 32, 36) erstrecken. Auf den Eckpunkten der Trapeze T werden die Kontaktiereinheiten 20 angebracht. Durch Optimierung der Abmessungen der Leiterbahnen, der nicht leitenden Bereiche und des Kontaktrasters können alle gängigen Möbelgrößen bedient werden.

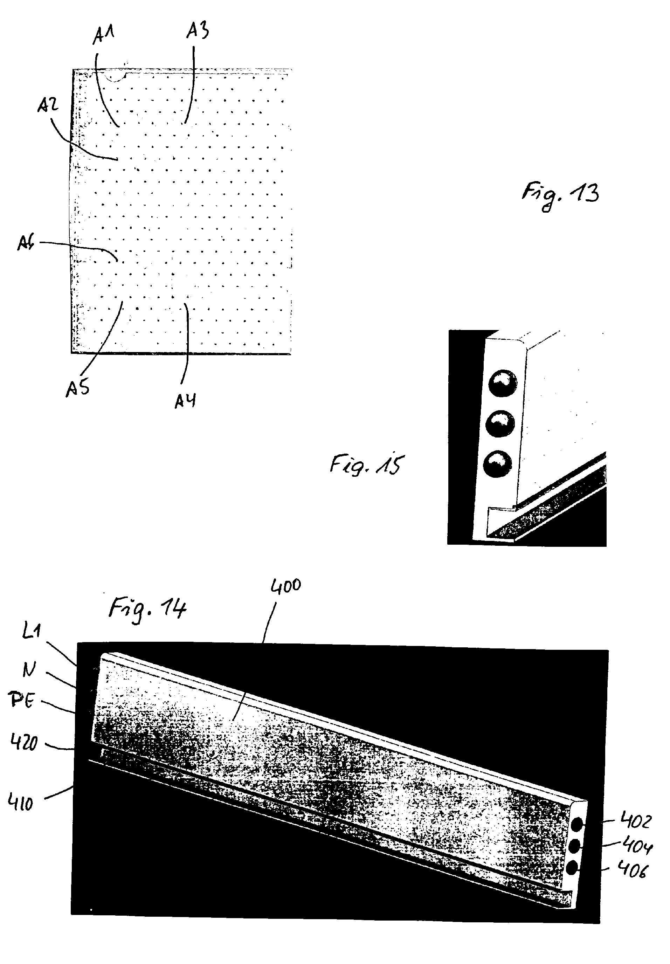

Figur 13 zeigt einen Bodenbelag mit einem derartigen Kontaktraster, auf dem sechs Arbeitsplätze A1, ... A6 aufgebaut sind. Man erkennt, dass jeder der Arbeitsplätze A1, ... A6 Kontaktiereinheiten des Kontaktrasters belegt.

Figur 14 zeigt in einer perspektivischen Ansicht eine Sockelleiste 400, welche eine Schutzkleinspannung von bis zu 40 V DC in die Leiterbahnen der Unterlageschicht eines erfindungsgemäßen Belages einträgt. Drei Reihenverbinder L1, N und PE bilden Anschlüsse für Phase, Nullleiter und Schutzleiter, z. B. bei 230 V AC, wobei innerhalb der Sockelleiste 400 ein (nicht dargestellter) Wandler vorgesehen ist, der diese Spannung in die gewünschte Schutzkleinspannung umwandelt. Damit ist es möglich, den Raum, der mit dem erfindungsgemäßen System ausgestattet ist, praktisch frei von Elektrosmog zu halten, da nahe dem Arbeitsplatz nur die Schutzkleinspannung herrscht. Der Belag wird zwischen einer Klemmschiene 410 und einem Klemmkeil 420 gehalten. Die Klemmschiene 410 trägt die Schutzkleinspannung in die Unterlage des Belags ein. Von oben drückt ein Klemmkeil (420) den Belag zur Kontaktierung flächig auf die Klemmschiene 410.

Figur 15 zeigt eine Stirnansicht der Sockelleiste der Figur 14, auf der die drei Reihenverbinder L1, N, PE deutlich als halbkugelige Kontakte zu erkennen sind, die bei der Montage mehrerer Sockelleisten 400 in entsprechende Ausnehmungen 402, 404, 406 auf der hinteren Stirnseite einer weiteren Sockelleiste 400 (Figur 14) greifen.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. System zur Energie- und/oder Datenbereitstellung, umfassend
einen Belag (10) aus textilem Baustoff mit einer Nutzfläche (12), wobei auf der Nutzfläche ein Kontaktraster aufgebaut ist, das aus im Wesentlichen nutzflächenbündig oder versenkt in den Belag eingelassenen Kontaktiereinheiten (20) aufgebaut ist, **gekennzeichnet durch**
eine Unterlageschicht (14), die Leiterbahnen (30, 34, 38) abwechselnder Polarität aufweist, welche **durch** nichtleitende Bereiche (32, 36) voneinander isoliert sind,
wobei zumindest ein Teil der Kontaktiereinheiten (20) im elektrischen Kontakt mit einer Leiterbahn einer ersten Polarität und mit einer Leiterbahn einer zweiten Polarität ist.

2. System nach Anspruch 1, **dadurch gekennzeichnet, dass** die Leiterbahnen (30, 34, 38) flächige Leiterbahnen sind.

3. System nach Anspruch 1, **dadurch gekennzeichnet, dass** die Leiterbahnen (30, 34, 38) parallel zueinander geführt sind.

4. System nach Anspruch 1, **dadurch gekennzeichnet, dass** die Leiterbahnen (30, 34, 38) untereinander die gleiche Breite aufweisen und die nichtleitenden Bereiche (32, 36) untereinander die gleichen Breite aufweisen

5. System nach Anspruch 1, **dadurch gekennzeichnet, dass** das Kontaktraster aus identischen Polygonen (T) aufgebaut ist, wobei die Ecken der Polygone mit jeweils einer Kontaktiereinheit (20) belegt sind.

6. System nach Anspruch 4, **dadurch gekennzeichnet, dass** die Polygone (T) gleichseitige Trapeze sind, deren einer Durchmesser der Summe aus der gesamten Breite zweier benachbarter Leiterbahnen (z. B. 30, 34) und den Zweifachen der Breite eines nichtleitenden Bereiches (32, 36) entspricht.

7. System nach Anspruch 1, weiter mit einer elektronischen Sockelleiste (400), welche eine Schutzkleinspannung bis zu 40V DC in die Leiterbahnen (30, 34, 38) der Unterlageschicht (14) prägt.

8. System nach Anspruch 7, **dadurch gekennzeichnet, dass** die Sockelleiste (400) einen Wandler 230V AC nach bis zu 40V DC aufweist.

9. System nach Anspruch 7 oder 8, **gekennzeichnet durch** eine Sockelleiste (400) mit mindestens jeweils einem Reihenverbinder (L1, N, PE) für Phase, Nullleiter und Schutzleiter.

10. Kontaktiereinheit zum Kontaktieren von Leiterbahnen unterschiedlicher Polarität und zum Weiterleiten von Energie und/oder Daten, mit
einem Rahmen (202) aus elektrisch isolierendem Material, in dem eine erste Kontaktplatte (206) und eine zweite Kontaktplatte (208) elektrisch isoliert voneinander gehalten sind,
mindestens einem Kontaktbein (210) zum Kontaktieren einer Leiterbahn einer ersten Polarität, das sich von der ersten Kontaktplatte (206) erstreckt,
mindestens einem Kontaktbein (212) zum Kontaktieren einer Leiterbahn einer zweiten Polarität, die von der ersten Polarität unterschiedlich ist, das sich von der zweiten Kontaktplatte (208) erstreckt,
wobei die erste Kontaktplatte (206) und die zweite Kontaktplatte (208) in einer gemeinsamen Ebene liegend angeordnet sind und sich die Kontaktbeine (210, 212) im Wesentlichen senkrecht zu der Ebene erstrecken.

11. Kontaktiereinheit nach Anspruch 10, **dadurch gekennzeichnet, dass** jeder Kontaktplatte (206, 208) zwei voneinander beabstandete Kontaktbeine (210, 216; 212, 214) zugeordnet sind, welche Eingriffsmittel zum Halten einer die Kontaktbeine verbindenden Klemmbrücke (220, 222) aufweisen.

12. Stromversorgung für Geräte insbesondere im Office-Bereich, mit einem System zur Energie- und/oder Datenbereitstellung nach einem der Ansprüche 1 bis 9, wobei eine Vielzahl von Kontaktiereinheiten nach Anspruch 10 oder 11 verwendet wird, weiter mit Stromzuführungen für die Versorgung der Geräte, welche durch oder entlang von Möbelabschnitten geführt sind, die zur Auflage auf eine Bodenfläche bestimmt sind, wobei die Stromzuführungen auf ein Paar federvorbelasteter Kontakte (40, 42) geführt sind, welche entsprechend den Abmessungen der Kontaktplatten (206, 208) einer Kontaktiereinheit (20) dimensioniert sind.
